# EUROPEAN PATENT SPECIFICATION

(11) **EP 0 597 526 B1**
(45) Date of publication and mention of the grant of the patent: **23.09.1998**
(21) Application number: 93203076.0
(22) Date of filing: 03.11.1993
(51) Int. Cl.: G11B 5/31, G11B 5/40, G11B 5/39

(54) **Method of manufacturing a magnetic head, and magnetic head manufactured by means of said method**
Herstellungsverfahren für einen Magnetkopf und mit dieser Methode hergestellter Magnetkopf
Procédé pour fabriquer une tête magnétique, et tête magnétique fabriquée par cette méthode

(30) Priority: 09.11.1992 EP 92203426
(43) Date of publication of application: 18.05.1994
(73) Proprietor: Koninklijke Philips Electronics N.V., 5621 BA Eindhoven (NL)
(72) Inventor: Pronk, Franciscus Antonius, c/o Int. Octrooi. B.V., NL-5656 AA Eindhoven (NL); Bril,Thijs Willem, c/o Int. Octrooi. B.V., NL-5656 AA Eindhoven (NL); Knapen, Peter Simon, c/o Int. Octrooi. B.V., NL-5656 AA Eindhoven (NL); Van Heeren, Arie Hendrik, c/o Int. Octrooi. B.V., NL-5656 AA Eindhoven (NL); Rhijnsburger, Laurens Jan, c/o Int. Octrooi. B.V., NL-5656 AA Eindhoven (NL)
(74) Representative: Schrijnemaekers, Hubert Joannes Maria

(56) References cited:
- DE-A- 3 342 429
- US-A- 4 558 385
- US-A- 4 759 118
- THIN SOLID FILMS, vol. 189,no. 1, August 1990 LAUSANNE CH, pages 161-173, KANG C.J. ET AL. 'Properties of Aluminium Oxide Films Prepared by Plasma-Enhanced Metal-Organic Chemical Vapour Deposition'
- PATENT ABSTRACTS OF JAPAN vol. 011 no. 378 (P-645) ,10 December 1987 & JP-A-62 146418 (NEC CORP) 30 June 1987,
- PATENT ABSTRACTS OF JAPAN vol. 009 no. 296 (P-407) ,22 November 1985 & JP-A-60 131606 (NIPPON DENKI KK) 13 July 1985,
- PATENT ABSTRACTS OF JAPAN vol. 012 no. 303 (P-746) ,18 August 1988 & JP-A-63 074110 (FUJI PHOTO FILM CO LTD) 4 April 1988,
- PATENT ABSTRACTS OF JAPAN vol. 010 no. 048 (P-431) ,25 February 1986 & JP-A-60 193114 (HITACHI SEISAKUSHO KK) 1 October 1985,
- PATENT ABSTRACTS OF JAPAN vol. 008 no. 023 (P-251) ,31 January 1984 & JP-A-58 179938 (NIPPON DENKI KK) 21 October 1983,

## Description

The invention relates to a method of manufacturing a magnetic head as defined in the preamble of claim 1, in which a transducing structure comprising at least a transducing element is formed on a substrate by means of a thin-film technique and in which a coating is provided on an uneven surface, remote from the substrate, of the structure formed.

Such a method is known from JP-A 62-146418. In the known method a protective coating of Al₂O₃ is provided by means of sputtering after a thin-film structure comprising an inductive transducing element and a magnetic circuit with a transducing gap has been formed. A drawback of the known method is that the rate at which Al₂O₃ can be deposited on said structure is limited. Since a thick coating is generally required, this leads to a relatively long deposition time which, from a production-technical point of view, is unfavourable because this results in a long manufacturing time of the magnetic head.

Thin Solid Films, 189 (1990) 161-173: XP 000151022 describes experiments relating to Al₂O₃ films deposited by PE-CVD on silicon substrates, especially as dielectric material for microelectronics JP-A-60 193 114, on which the preamble of claim 1 is based discloses the forming of a relatively thick coating on a thin-film head structure in order to prepare the structure to adhere a protective plate. The coating is lapped down after formation where after the protective plate is adhered to the lapped coating. The coating is formed by a sputtering method.

DE-A-33 42 429 discloses the usage of CVD during manufacturing thin-film magnetic heads for forming an insulating layer on a magnetic substrate provided with a coil layer during manufacturing of a thin-film structure. On the insulating layer a coating layer is formed by means of a spin-coating method in order to planarize an area above the coil layer. On the coating layer a magnetic upper core is formed.

It is an object of the invention to improve the method described in the opening paragraph in such a way that the time of manufacturing the magnetic head can be reduced.

To this end the method according to the invention is characterized as defined in claim 1 in that the surface of the transducing structure remote from the substrate is provided by means of PE-CVD with a thick film forming the coating and having a thickness which is minimally equal to the distance between an area of said surface which is farthest remote from the substrate and an area which is most proximate to the substrate. The transducing structure may be provided with an inductive transducing element and/or a magnetoresistive transducing element.

By using a Plasma Enhanced Chemical Vapour Deposition process (PE-CVD process) for forming the coating on the transducing structure of a magnetic head, the manufacturing time can be considerably reduced as compared with the time required for the known method. As compared with sputtering, PE-CVD has the additional advantage that sharp or stepped surface portions of the transducing structure are better coated. The thick film formed by means of PE-CVD generally has a thickness of between 5 µm and 50 µm, dependent on the surface unevenness of the transducing structure.

It is to be noted that it is known *per se* to use a PE-CVD process for providing a thin film on a surface. In this connection reference is made to US 4,789,910.

An embodiment of the method according to the invention is characterized in that, prior to providing the coating, a thin shielding layer is formed on the transducing structure, on which layer the thick film is provided by means of PE-CVD. The shielding layer provided on the transducing structure prevents the gases used during the PE-CVD process from coming into contact with the materials of the transducing structure and thus prevents unwanted chemical reactions and attack of the transducing structure. The shielding layer which has a composition which is resistant to the gases being present during PE-CVD may also enhance the adhesion of the thick film to the transducing structure.

An embodiment of the method according to the invention is characterized in that at least one of the materials SiO₂, Al₂O₃, Si₃N₄, TaO₂ is deposited by means of PE-CVD for forming the thick film. It has been found that a silicon oxide nitride (SiOₓN_{y}) is favourable as a deposition material for forming the thick film by means of PE-CVD.

In this range of materials, SiO₂ is preferred due to its favourable process properties and due to the great hardness and wear resistance of the deposited thick film. The latter is particularly important to inhibit hollowing during the formation of a head face on a magnetic head to be manufactured and during use of the manufactured magnetic head.

An embodiment of the method according to the invention is characterized in that at least one of the electrically non-conducting materials SiO₂, Al₂O₃, ZrO₂ is used for forming the shielding layer. The thin shielding layer having a maximum thickness of several microns, but preferably smaller than 1 µm, can be formed by means of, for example a sputtering process.

An embodiment of the method according to the invention is characterized in that PE-CVD is performed at a process temperature between 100°C and 300°C. This relatively low temperature prevents the substrate and the transducing structure from being subjected to a heavy thermal load so that large expansions of material during PE-CVD are inhibited. This has the advantage that there is only limited shrinkage during cooling so that, in contrast to what was expected, no harmful stress is generated in the thick film, which results in a stable coating without any cracks. Further favourable process parameters are: a RF frequency of 375 Hz and a SiH₄/N₂O gas flow in which the ratio between SiH₄ and N₂O is between 1:10 and 1:30. A mixing frequency of 13.5 MHz may be used.

In order to provide the magnetic head to be manufactured with electric connection means, an embodiment is characterized in that an electrically conducting connection element is provided prior to forming the coating, while the shielding layer, when being formed, is also provided on the connection element, whereafter the shielding layer thus formed is coated with the thick film during PE-CVD. The connection element may be a conducting strip or layer of, for example copper having a thickness of several tens of microns. By providing a shielding layer on the connection element, a possible reaction between the electrically conducting material of the connection element and the gas or gases present during the PE-CVD process is prevented. The shielding layer may also be used as an adhesive layer.

To protect the transducing structure of the magnetic head to be manufactured, an embodiment of the method according to the invention is characterized in that, after planing, a protective element is secured to the thick film provided by means of PE-CVD. Planing may be performed, for example with CeO₂. A thin adhesive layer may be used as a securing means between the coating and the protective element.

An embodiment of the method according to the invention is characterized in that a portion of the thick film situated opposite the connection element is removed during planing for forming an electric connection face. In accordance with this embodiment, an electric connection face is obtained in an efficient manner, without extra process steps being required.

The invention also relates to a magnetic head manufactured by means of the method according to the invention. The magnetic head according to the invention is characterized in that a PE-CVD coating is present on the transducing structure. A protective element may be present on the PE-CVD coating. A magnetic head which has a very high wear resistance is obtained if the PE-CVD coating at least substantially comprises SiO₂.

These and other aspects of the invention will be apparent from and elucidated with reference to the embodiments described hereinafter.

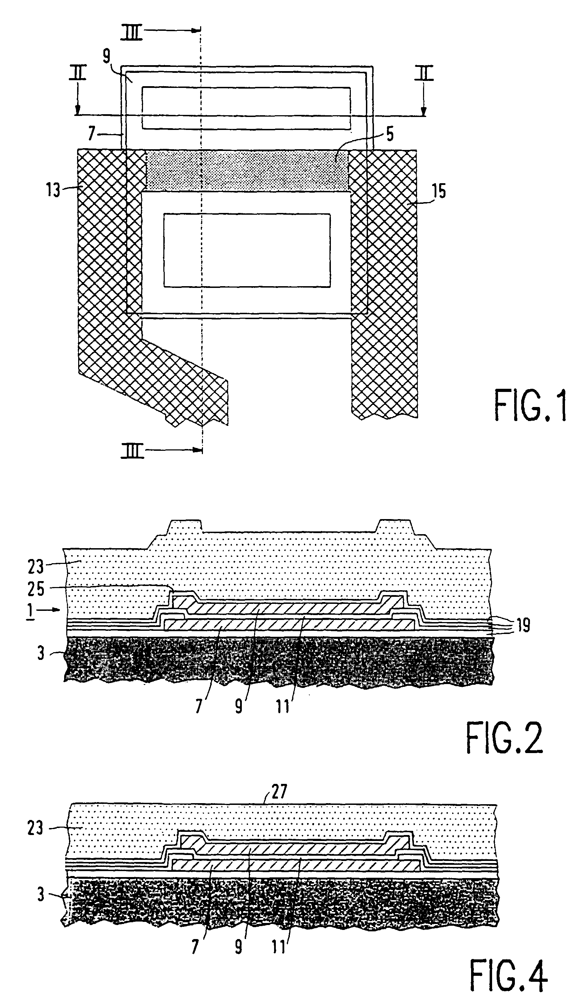

In the drawings
Fig. 1 is a plan view of a transducing structure,
Fig. 2 is a cross-section taken on the line II-II in Fig. 1, in which the transducing structure has a coating provided by means of an embodiment of the method according to the invention,

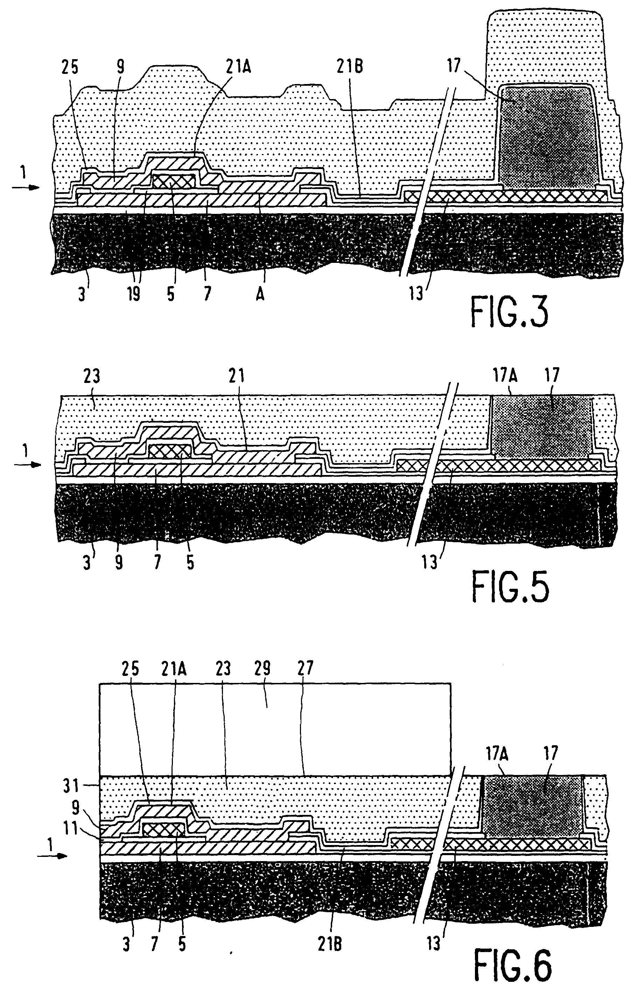

Fig. 3 is a cross-section taken on the line III-III in Fig. 1, in which the transducing structure is provided with the coating,
Fig. 4 is a cross-section taken on the line II-II showing the transducing structure according to Figs. 2 and 3 after the coating has been planed,
Fig. 5 is a cross-section taken on the line III-III showing the structure according to Fig. 4 and
Fig. 6 is a cross-section taken on the line III-III showing an embodiment of the magnetic head according to the invention.

The transducing structure 1 shown in the Figures is provided on a substrate 3 by means of thin-film techniques such as vacuum deposition, etching, lithography. In this embodiment the substrate 3 is formed from a non-magnetic material, for example Al₂O₃/TiC. However, if desired, the substrate may be magnetic and formed, for example from a ferrite. In this embodiment the transducing structure 1 is provided with an inductive transducing element 5 and a magnetic yoke comprising a first flux guide 7 and a second flux guide 9. A non-magnetic transducing gap 11 of, for example SiO₂ extends between the flux guides 7 and 9 which are formed from, for example NiFe. The flux guides 7 and 9 are magnetically interconnected in an area A. The transducing element 5 is electrically connected at two ends to electrically conducting layers 13 and 15 which make electric contact with copper connection elements 17. Instead of or additionally to the inductive transducing element 5, the transducing structure may be provided with a magnetoresistive element. In the embodiment shown electrically insulating layers 19 of, for example SiO₂ are provided between various layers.

As a result of the manufacturing technique used, the transducing structure 1 has an uneven surface 21 remote from the substrate, with an area, or roof, 21A being farthest remote from the substrate 3 and an area, or trough, 21B being most proximate to the substrate 3. In accordance with the inventive method the transducing structure 1 is planarized by providing a coating 23 by means of a PE-CVD process, which coating has a thickness which is at least equal to the distance between the areas 21A and 21B, and by subsequently planing this coating. In this embodiment a thick film of SiO₂ forming the coating 23 is deposited. Before the PE-CVD is started, a thin oxidic shielding layer 25, of Al₂O₃ in this embodiment, having a thickness of 0.25 microns is deposited by means of, for example a sputtering process.

In this embodiment the shielding layer 25 and the coating 23 is provided on the transducing structure 1 as well as on the connection elements 17. The shielding layer of Al₂O₃ also serves as an adhesive layer between the copper of the connection elements 17 and the SiO₂ coating.

A thick film forming the coating 23 can be provided by means of known PE-CVD apparatus. The following parameters were used in an experiment for forming the thick film having a thickness of 30 µm in this embodiment: a RF frequency of 375 kHz, a SiH₄/H₂O gas flow in a ratio of 1:20; a process temperature of 225°C. It was surprisingly found that with these parameters, and generally with the parameters within the limits stated in the introductory part of this description, the thick film formed was free from cracks and did not have any crumbling.

The coating 23 formed is subsequently provided with a plane surface 27 for which, for example CeO₂ can be used as a polishing agent. When the coating 23 is being planed, the connection elements 27 are cut through so as to form connection faces 17a. To protect the transducing structure, a protective element 29 is glued onto the surface 27 of the coating 23. The assembly obtained is subsequently provided with a head face 31 by grinding and/or polishing. It was surprisingly found that, due to the favourable wear resistance of the coating 23, hollowing was prevented entirely or at least to a great extent during formation of the head face 31.

The magnetic head thus formed in accordance with the invention is suitable for cooperating with a magnetic medium, particularly a magnetic tape or disc.

## Claims

1. A method of manufacturing a magnetic head, comprising forming a thin-film structure (1) on a surface of a substrate (3), which structure includes a transducing element (5) and comprises a magnetic circuit, resulting in an uneven surface (21) of the structure formed, remote from the substrate, and depositing material for forming a relatively thick coating (23) on the uneven surface, whereafter the coating is planarized for forming an even surface, whereafter a protective element (29) is secured to the even surface, characterized in that the relatively thick coating (23) on the thin-film structure is provided by means of PE-CVD, which coating has a thickness which is minimally equal to the distance between an area of the uneven surface (21) which is farthest remote from the surface of the substrate (3) and an area which is most proximate to the surface of the substrate.

2. A method as claimed in Claim 1, characterised in that, prior to providing the coating (23), a thin shielding layer (25) is formed on the thin film structure (1), on which layer the thick film is provided by PE-CVD.

3. A method as claimed in Claim 1 or 2, characterised in that at least one of the materials selected from the group consisting of SiO₂, Al₂O₃, ZrO₂ is used for forming the shielding layer (25).

4. A method as claimed in Claim 1 or 2, characterised in that a silicon oxide nitride is deposited by PE-CVD for forming the thick film.

5. A method as claimed in Claim 3 or 4, characterised in that at least one of the electrically non-conducting materials selected from the group consisting of SiO₂, Al₂O₃, ZrO₂ is used for forming the shielding layer (25).

6. A method as claimed in Claim 1, 2, 3, 4 or 5, characterised in that PE-CVD is performed at a process temperature between 100°C and 300°C.

7. A method as claimed in any one of the preceding Claims, characterised in that the thick film formed by PE-CVD has a thickness of between 5 µm and 50 µm, dependent on the surface unevenness of the uneven surface.

8. A method as claimed in Claim 2, characterised in that an electrically conducting connection element (17) is provided prior to forming the thick film, while the shielding layer, (25) when being formed, is also provided on the connection element, whereafter the shielding layer thus formed is coated with the thick film during PE-CVD.

9. A method as claimed in Claim 8, characterized in that a portion of the thick film situated opposite the connection element (17) is removed during planarization forming an electric connection face.

10. A magnetic head manufactured by means of a method as claimed in any one of the preceding Claims, characterized in that a PE-CVD film is present on the thin film structure (1).

## Patentansprüche

1. Verfahren zum Herstellen eines Magnetkopfes wobei dieses Verfahren die nachfolgenden Verfahrensschritte umfaßt: das Bilden einer Dünnfilmstruktut (1) auf einer Oberfläche eines Substrats (3), wobei diese Struktur ein Übertragungselement (5) umfaßt und einen Magnetkreis aufweist, was zu einer unebenen Oberfläche (21) der gebildeten Struktur führt, in einem Abstand von dem Substrat und das Niederschlagen von Material zum Bilden einer relativ dicken Deckschicht (23) auf der unebenen Oberfläche, wonach die Deckschicht geglättet wird zum Bilden einer ebenen Oberfläche, wonach ein Schutzelement (29) auf der ebenen Oberfläche angebracht wird, dadurch gekennzeichnet, daß die relativ dicke Deckschicht (23) auf der Dünnfilmstruktur im PE-CVD-Verfahren angebracht wird, wobei diese Deckschicht eine Dicke hat, die dem Abstand zwischen einem Gebiet der unebenen Oberfläche (21), das am weitesten von der Oberfläche des Substrats (3) entfernt ist und einem Gebiet, das der Oberfläche des Substrats amnächsten ist, minimal entspricht.

2. Verfahren nach Anspruch 1, dadurch gekennzeichnet, daß bevor die Deckschicht (23) angebracht wird, eine dünne Schutzschicht (25) auf der Dünnfilmstruktur (1) gebildet wird, worauf der Dickfilm im PE-CVD-Verfahren angebracht wird.

3. Verfahren nach Anspruch 1 oder 2, dadurch gekennzeichnet, daß zum Bilden der Schutzschicht (25) wenigstens einer der Werkstoffe, selektiert aus der Gruppe SiO₂, Al₂O₃, ZrO₂ verwendet wird.

4. Verfahren nach Anspruch 1 oder 2, dadurch gekennzeichnet, daß zum Bilden des Dickfilms im PE-CVD-Verfahren ein Siliziumoxidnitrid niedergeschlagen wird.

5. Verfahren nach Anspruch 3 oder 4, dadurch gekennzeichnet, daß zum Bilden der Schutzschicht (25) wenigstens einer der elektrisch nicht-leitenden Werkstoffe, selektiert aus der Gruppe, bestehend aus SiO₂, Al₂O₃, ZrO₂, verwendet wird.

6. Verfahren nach Anspruch 1, 2, 3, 4 oder 5, dadurch gekennzeichnet, daß das PE-CVD-Verfahren bei einer Verfahrenstemperatur zwischen 100°C und 300°C durchgeführt wird.

7. Verfahren nach einem der vorstehenden Ansprüche, dadurch gekennzeichnet, daß der im PE-CVD-Verfahren gebildete Dickfilm eine Dicke zwischen 5 µm und 50 µm hat, je nach der Oberflächenbeschaffenheit der unebenen Oberfläche.

8. Verfahren nach Anspruch 2, dadurch gekennzeichnet, daß bevor die Deckschicht gebildet wird, ein elektrisch leitendes Anschlußelement (17) angebracht wird, wobei beim Bilden der Schutzschicht (25), diese Schicht zugleich über das Anschlußelement angebracht wird, wonach beim Durchführen des PE-CVD-Verfahrens die auf diese Weise gebildete Schutzschicht mit dem Dickfilm bedeckt wird.

9. Verfahren nach Anspruch 8, dadurch gekennzeichnet, daß ein Teil des Dickfilms gegenüber dem Anschlußelement (17) beim Glätten entfernt wird, wodurch eine elektrische Anschlußfläche gebildet wird.

10. Magnetkopf, hergestellt nach einem Verfahren nach einem der vorstehenden Ansprüche, dadurch gekennzeichnet, daß auf der Dünnfilmstruktur (1) ein PE-CVD-Film vorhanden ist.

## Revendications

1. Procédé pour fabriquer une tête magnétique comportant la formation d'une structure à film mince (1) sur une surface d'un substrat (3), ladite structure incorporant un élément transducteur (5) et comportant un circuit magnétique, ce qui a pour conséquence une surface peu égale (21) de la structure formée située à l'opposé du substrat, et comportant le dépôt de matériau pour constituer une couche de couverture relativement épaisse (23) sur la surface peu égale, après quoi la couche de couverture est aplanie pour constituer une surface égale, après quoi un élément protecteur (29) est fixé à la surface égale, caractérisé en ce que la couche de couverture relativement épaisse (23) située sur la structure à film mince est déposée au moyen d'un processus dit PE-CVD, ladite couche de couverture ayant une épaisseur qui est tout au moins égale à la distance comprise entre une zone de la surface peu égale (21) étant le plus éloignée de la surface du substrat (3) et une zone étant le plus proche de la surface du substrat.

2. Procédé selon la revendication 1, caractérisé en ce que. avant le dépôt de la couche de couverture (23), une couche de protection mince (25) est formée sur la structure à film mince (1), couche sur laquelle le film épais est déposé au moyen d'un processus dit PE-CVD.

3. Procédé selon la revendication 1 ou 2, caractérisé en ce qu'au moins un des matériaux choisis parmi le groupe constitué de SiO₂, de Al₂O₃, de ZrO₂ s'utilise pour constituer la couche de protection (25).

4. Procédé selon la revendication 1 ou 2, caractérisé en ce qu'un nitrure d'oxyde de silicium est déposé au moyen du processus dit PE-CVD pour constituer le film épais.

5. Procédé selon la revendication 3 ou 4, caractérisé en ce qu'au moins un des matériaux électriquement non conducteurs choisis parmi le groupe constitué de SiO₂, de Al₂O₃, de ZrO₂ s'utilise pour constituer la couche de protection (25).

6. Procédé selon la revendication 1, 2, 3, 4 ou 5, caractérisé en ce que le processus dit PE-CVD s'effectue à une température de processus comprise entre 100°C et 300°C.

7. Procédé selon l'une quelconque des revendications précédentes, caractérisé en ce que le film épais formé au moyen du processus dit PE-CVD présente une épaisseur comprise entre 5 µm et 50 µm, en fonction de l'inégalité de surface de la surface peu égale.

8. Procédé selon la revendication 2, caractérisé en ce qu'un élément de connexion électriquement conducteur (17) est prévu avant la formation du film épais, alors que la couche de protection (25) en voie de formation est également déposée sur l'élément de connexion, après quoi la couche de protection ainsi formée est recouverte du film épais lors du processus dit PE-CVD.

9. Procédé selon la revendication 8, caractérisé en ce qu'une partie du film épais située à l'opposé de l'élément de connexion (17) est enlevée pendant l'aplanissement pour constituer une face de connexion électrique.

10. Tête magnétique fabriquée suivant un procédé selon l'une quelconque des revendications précédentes, caractérisée en ce qu'un film dit PE-CVD se situe sur la structure à film mince (1).
